# EUROPÄISCHE PATENTANMELDUNG

(11) **EP 0 755 083 A2**
(43) Veröffentlichungstag der Anmeldung: **22.01.1997**
(21) Anmeldenummer: 96108376.3
(22) Anmeldetag: 25.05.1996
(51) Int. Cl.: H01L 33/00

(54) **Diodenfassung für LED mit Steckverbindung und Vorwiderstand und Verfahren zu deren Herstellung**

(30) Priorität: 19.07.1995 DE 19526313
(71) Anmelder: Preh-Werke GmbH & Co. KG, 97616 Bad Neustadt (DE)
(72) Erfinder: Berthold, Gottfried, Dr., 72766 Reutlinger (DE); Rüttiger, Anton, 97772 Wildflecken (DE); Schmitt, Hans-Michael Dr., 97702 Münnerstadt (DE)
(74) Vertreter: Pfeiffer, Helmut, Dipl.-Ing.

(57) **Zusammenfassung**

Die Erfindung bezieht sich auf eine Diodenfassung für LED mit Steckverbindung und Vorwiderstand sowie deren Herstellung. Mittels Spritzguß wird ein einteiliges Gehäuse (1) mit danach eingebrachten LED (2) und Steckverbindung (3) hergestellt. Über eine elektrisch leitende Paste (5) wird die elektrische Verbindung von LED (2) und Steckverbindung (3) sowie deren mechanischen Fixierung realisiert. Gleichzeitig wirkt die elektrisch leitende Paste (5) als Vorwiderstand (4).

## Beschreibung

Die Erfindung bezieht sich auf eine Diodenfassung für LED mit Steckverbindung und Vorwiderstand gemäß dem Oberbegriff des Patentanspruchs 1 sowie auf mögliche Verfahren zu deren Herstellung.

Bekannt sind Diodenfassungen aus zwei Gehäusehälften. In der unteren Gehäusehälfte ist die LED mit den Vorwiderständen als Reihenwiderstand der LED auf einer Keramikplatte sowie die Steckverbindung mechanisch eingesetzt. Die LED-Anschlüsse und die Anschlüsse der Steckverbindung werden mit den Leiterbahnen der Widerstandskeramikplatte elektrisch verbunden, z. B. durch Hemmen, Schweißen oder Löten. Die obere Gehäusehälfte deckt das gesamte System ab. Die Befestigung der Einbauteile und der Gehäusehälften aufeinander erfolgt über Schnapphaken.

Zur Herstellung dieser Diodenfassung werden in einem Spritzgußverfahren beide Gehäusehälften mit Schnapphaken und Gegenkante in einem Spritzgußwerkzeug hergestellt. Der weitere Schritt ist die Herstellung der Widerstandsplatte. Dabei wird diese mit Leiterbahnen und Anschlußfläche bedruckt, danach gebrannt, mit einer Widerstandsschicht, z. B. Cermet-Paste, erneut bedruckt und wieder gebrannt. Die Widerstandskeramikplatte wird in Einzelplättchen getrennt. Es folgt das Einsetzen aller Einzelteile in die untere Gehäusehälfte, die Schaffung der Verbindung LED-Widerstand-Steckverbindung, der Widerstandsabgleich sowie das Verschließen beider Gehäusehälften.

Nachteilig bei der vorgenannten Lösung ist der komplizierte Aufbau der Diodenfassung sowie der hohe zeitliche und technologische Arbeitsaufwand zu deren Herstellung.

Die Aufgabe der Erfindung besteht darin, die Diodenfassung der eingangs genannten Art dahingehend zu verbessern, daß sie in ihrem Aufbau einfacher gestaltet und mit weniger Arbeitsschritten herstellbar ist.

Gelöst wird die Aufgabe durch die im kennzeichnenden Teil des Anspruchs 1 angegebenen Merkmale. Vorteilhafte Ausgestaltungen sind den Ansprüchen 1 bis 7 zu entnehmen. Anspruch 8 beschreibt ein Herstellungsverfahren, mit dem die Diodenfassung nach der Erfindung hergestellt werden kann. Vorteilhafte Ausgestaltungen sind in den Ansprüchen 9 bis 10 enthalten. Ein weiteres Verfahren zur Herstellung der erfindungsgemäßen Diodenfassung ist in Anspruch 11 enthalten.

Mittels eines Spritzgußverfahrens wird ein einteiliges Gehäuse hergestellt. Die äußere Form bestimmt sich z. B. durch den Kragen einer LED-Aufnahme und einer Steckverbindung, soll aber nicht näher beschrieben werden, da sie je nach Anforderung variabel ist. In dem Gehäuse befinden sich vorzugsweise Taschen mit kleinen Öffnungen. In diese Taschen wird eine elektrisch leitende Paste eingespritzt. Diese härtet aus und bildet nun Vorwiderstände für eine LED. Gleichzeitig mit der elektrischen Verbindung zwischen LED und Steckverbindung werden beide mechanisch fixiert. Die so hergestellte Diodenfassung mit LED, Steckverbindung und integrierten Vorwiderständen ist robust und sehr einfach im Aufbau, leicht als Ganzes auswechselbar und preiswert. Anwendung finden diese Diodenfassungn z. B. in Armaturenbrettern der Automobilbranche.

Im folgenden wird die erfinderische Lösung anhand von bevorzugten Ausführungsbeispielen im Zusammenhang mit den Zeichnungen ausführlicher erläutert. Es zeigt:
- Figur 1: eine Draufsicht der Diodenfassung
- Figur 2: einen Querschnitt (Schnitt A-A) der Figur 1 der Diodenfassung
- Figur 3: einen Schnitt längs der Linie B-B der Figur 2 in einer ersten Ausführungsform
- Figur 4: einen der Figur 3 entsprechenden Schnitt B-B, jedoch in einer abgewandelten Ausführungsform.

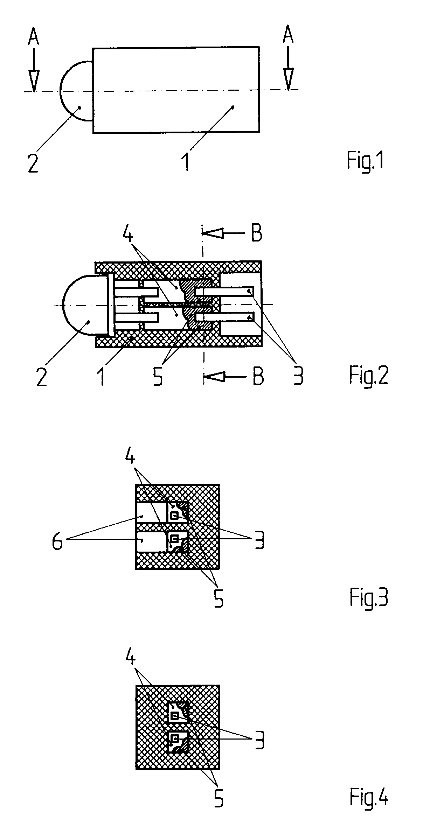

Die Diodenfassung ist prinzipiell aus einem einstückigen gespritzten Gehäuse 1, vorzugsweise Polyamid, aufgebaut (Figur 1). Mit Hilfe eines allgemein bekannten Spritzgußverfahrens und eines nicht näher erläuterten Spritzgußwerkzeugs wird zuerst das Gehäuse 1 gespritzt, in welchem sich vorzugsweise Taschen 6 befinden. In das Gehäuse 1 werden Kontaktstifte einer Steckverbindung 3 sowie Anschlüsse einer LED 2 eingedrückt bzw. eingesetzt. Durch Öffnungen in den Taschen 6 wird eine elektrisch leitende Paste 5, bestehend aus einem polymeren Bindemittel und eindispergiertem Leitpigment, vorzugsweise aus Carbon, eingespritzt (vgl. Fig. 2 und 3). Diese Paste 5 härtet aus und bildet Vorwiderstände 4 als Teilwiderstände eines Reihenwiderstandes für die LED 2. Mit den Vorwiderständen 4 werden auch die Kontaktstifte der Steckverbindung 3 elektrisch verbunden. Gleichzeitig mit der Aushärtung der elektrisch leitenden Paste 5 erfolgt eine mechanische Fixierung der LED 2 und der Steckverbindung 3 in der Diodenfassung, d. h. sie werden im Gehäuse 1 fest integriert, so wie auch die Vorwiderstände 4. Die Räumlichkeit der Taschen 6 und die Menge der Paste 5 bestimmen den groben Vorwiderstandsistwert. Der Feinabgleich der Vorwiderstände 4 erfolgt über einen nicht näher erläuterten Laser oder mechanischen Abgleich durch die Öffnungen in den Taschen 6.

Anstelle des vorstehend beschriebenen Herstellungsverfahrens kann die Diodenfassung auch im Zweischuß-Spritzgußverfahren hergestellt werden. Zuerst werden die Anschlüsse der LED 2 und die Kontaktstifte der Steckverbindung 3 in einen im einzelnen nicht näher beschriebenen Zweischuß-Spritzgußwerkzeug eingelegt und die elektrisch leitende Paste 5 im ersten Schuß eingespritzt. Diese bestimmt den groben Vorwiderstandsistwert. Die Paste 5 härtet aus und bildet die Vorwiderstände 4 als Teilwiderstände eines Reihenwiderstandes der LED 2. Gleichfalls erfolgt die elektrische Verbindung zwischen den Anschlüssen der LED 2 und den Kontaktstiften der Steckverbindung 3 sowie deren mechanische Fixierung. Mit dem zweiten Schuß wird das isolierende äußere Gehäuse 1 fest um die LED 2, Paste 5 und Steckverbindung 3 hergestellt.

Auch bei diesem Herstellungsverfahren kann das Gehäuse 1 Taschen 6 mit Öffnungen aufweisen, aber auch als geschlossenes Gehäuse dem Spritzgußwerkzeug entnommen werden (vgl. Fig. 4). Hierbei werden dann mittels sehr feinen, starken z. B. Laserstrahlen in das Gehäuse 1 sehr feine Öffnungen, vorzugsweise je Vorwiderstand 4 eine, eingebrannt, so daß der Feinabgleich der Vorwiderstände 4 durch diese Öffnungen erfolgen kann.

Es versteht sich, daß die Erfindung nicht nur auf die dargestellten Ausführungsbeispiele beschränkt ist, sondern im Rahmen der Ansprüche Abänderungen zuläßt. So kann die Steckverbindung 3 senkrecht zur LED 2 angeordnet sein. Auch die Anwendung der Spritzgußverfahren läßt einen entgegenlaufenden Verfahrensablauf zu, d. h. in dem Ausführungsbeispiel, wo die Herstellung über das äußere Gehäuse 1 nach innen erfolgt, kann diese von innen nach außen erfolgen und wo die Herstellung von innen nach außen beschrieben wurde, entgegengesetzt. Das äußere Gehäuse 1 kann statt der eckigen Form auch eine runde im Schnitt B-B aufweisen.

## Patentansprüche

1. Diodenfassung für LED (2) mit Steckverbindung (3) und Vorwiderstand (4), **dadurch gekennzeichnet**, daß die Diodenfassung aus einem einteiligen Gehäuse (1) zur Aufnahme der LED (2), der Steckverbindung (3) und Vorwiderstände (4) besteht.

2. Diodenfassung nach Anspruch 1, **dadurch gekennzeichnet**, daß die Vorwiderstände (4) durch eine elektrisch leitende Paste (5) gebildet werden.

3. Diodenfassung nach Anspruch 2, **dadurch gekennzeichnet**, daß über die elektrisch leitende Paste (5) eine Kontaktierung und mechanische Fixierung der LED (2) und Steckverbindung (3) erfolgt.

4. Diodenfassung nach Anspruch 2 bis 3, **dadurch gekennzeichnet**, daß das Gehäuse (1) zur Aufnahme der elektrisch-leitenden Paste (5) Taschen (6) aufweist.

5. Diodenfassung nach Anspruch 4, **dadurch gekennzeichnet**, daß die Taschen (6) einen groben Vorwiderstandsistwert bestimmen.

6. Diodenfassung nach einem oder mehreren der Ansprüche 2 bis 5, **dadurch gekennzeichnet**, daß die elektrisch leitende Paste (5) aus einem polymeren Bindemittel mit eindispergiertem Leitpigment, vorzugsweise aus Carbon besteht.

7. Diodenfassung nach einem oder mehreren der Ansprüche 1 bis 6, **dadurch gekennzeichnet**, daß das Gehäuse (1) aus Polyamid besteht.

8. Verfahren zur Herstellung einer Diodenfassung nach den Ansprüchen 1 bis 7, **dadurch gekennzeichnet**, daß mittels Spritzgußverfahren ein einteiliges Gehäuse (1) mit vorzugsweise Taschen (6) hergestellt wird.

9. Verfahren nach Anspruch 8, **dadurch gekennzeichnet**, daß Kontaktstifte der Steckverbindung (3) und Anschlüsse der LED (2) in das Gehäuse (1) eingesetzt werden, so daß sie in die Taschen (6) hinseitig hineinragen.

10. Verfahren nach den Ansprüchen 8 bis 9, **dadurch gekennzeichnet**, daß mittels einer Dosiereinrichtung eine elektrisch leitende Paste (5) in die Taschen (6) eingespritzt wird und die elektrisch leitende Raste (5) aushärtet.

11. Verfahren zur Herstellung einer Diodenfassung nach den Ansprüchen 1 bis 7, **dadurch gekennzeichnet**, daß die Anschlüsse der LED (2) und Kontaktstifte der Steckverbindung (3) in ein Zweischuß-Spritzgußwerkzeug einlegt werden, mit dem ersten Schuß eine elektrisch leitende Raste (5) eingespritzt und mit dem zweiten Schuß ein äußeres, nicht leitendes Gehäuse (1) hergestellt wird.
